# EUROPEAN PATENT APPLICATION

(11) **EP 0 729 099 A1**
(43) Date of publication of application: **28.08.1996**
(21) Application number: 96300663.0
(22) Date of filing: 31.01.1996
(51) Int. Cl.: G06F 11/20

(54) **Mirror storage controller**

(30) Priority: 13.02.1995 JP 24423/95
(71) Applicant: TSUBASA SYSTEM CO. LTD., Tokyo (JP)
(72) Inventor: Sakai, Michimoto, c/o Tsubasa System Co., Ltd., Tokyo (JP)
(74) Representative: Mackenzie, Andrew Bryan

(57) **Abstract**

A signal control unit of a connecting equipment, when receiving a write instruction from a CPU, transmits the write instruction to a first HDD on condition that a value of a first HDD status holding memory indicates that no fault happens in the first HDD. The signal control unit also transmits this write instruction to a second HDD on condition that a value of the second HDD status holding memory indicates that no fault happens in the second HDD.

## Description

### BACKGROUND OF THE INVENTION

### 1. Field of the Invention

The present invention relates generally to a computer system equipped with a plurality of external storage devices such as hard disks, etc. and an external storage device switching equipment for selectively connecting the plurality of external storage devices to the computer system. The present invention relates more particularly to a computer system and a repeater capable of maintaining and managing data.

### 2. Description of the Related Art

A dominant large-capacity external storage device for a computer system has hitherto been a tape type magnetic medium. In the present situation, however, a hard disk which is best-balanced in terms of large-capacity and high-speed performances is employed as the large-capacity external storage device for the computer system. In a personal computer wherein a low-capacity storage device such as a floppy disk, etc. has been used mainly as an external storage device, the hard disk is employed with a decrease in price of the hard disk.

However, the hard disk exhibits the above advantages on one hand and has a characteristic of being weak against an impact on the other hand. Further, as explained earlier, the hard disk has the large capacity, and, therefore, once a fault happens therein enough to destruct all of storage contents, damages thereof are tremendous. Under such circumstances, Japanese Patent Laid-Open Publication No.1-276354 proposes a mirror disk system (mirror hard disk). According to this mirror hard disk, two pieces of hard disk drives (hereinafter abbreviated to HDD) are connected to the computer system, and the respective HDDs are invariably stored with the same data to back up each other. Then, if the fault is caused, the computer system is operated by use of only the normal HDD.

The conventionally proposed mirror disk system is, however, actualized by a special control program executed within a CPU (Central Processing Unit) of the computer. This control program performs control to monitor a processing status of each HDD. Then, the control program effects control to write the same data to the plurality of HDDs (active system HDD and backup system HDD) and to read the data from the active system HDD. If the fault happens in the active system HDD, the control program implements the control to write the data to only the backup system HDD and to read the data therefrom. Accordingly, for incorporating the conventionally proposed mirror disk system into the existing computer system, the exclusive-use HDDs corresponding to the control program have to be incorporated en bloc in addition to this control program. That is, the HDDs used before incorporating the mirror disk system can not be employed as the HDDs for the mirror disk system. As a result, an amount of investment at an initial stage is huge, and the existing HDDs are futile.

It is a primary object of the present invention, which was devised in view of such problems inherent in the prior art, to provide a computer system capable of eliminating a necessity for exclusive-use software executed in the computer system and maintaining the data with existing external storage devices by actualizing a mirror disk system with the aid of a repeater as a hardware element and also provide a repeater used therefor.

### SUMMARY OF THE INVENTION

A computer system according to the present invention comprises a central processing unit, a plurality of external storage devices and a repeater, connected to the central processing unit and the plurality of external storage devices, for transmitting a data write instruction for one specified external storage device among the plurality of external storage devices which is given from the central processing unit to the specified external storage device and other external storage devices as well.

Further, a repeater according to the present invention is connected between a central processing unit and a plurality of external storage devices and transmits a data write instruction for one specified external storage device among the external storage devices which is given from the central processing unit to the specified external storage device and other external storage devices as well.

Thus, the write instruction transmitted from the central processing unit to the specified external storage device is transmitted also to other external storage devices. Hence, mirroring of the external storage devices can be performed without the special software executed in the central processing unit. Further, the existing storage devices can be also used as the external storage devices.

Note that if the corresponding sector-basis synchronization is taken with respect to the update external storage device and the backup external storage device when transmitting the write instruction, mutual matching of storage contents thereof can be physically ensured, and a reliability on the system can be enhanced without depending on the special software.

### BRIEF DESCRIPTION OF THE DRAWINGS

The present invention will become more fully understood from the detailed description given hereinbelow and the accompanying drawings which are given by way of illustration only, and thus are not limitative of the present invention, and wherein:
FIG. 1 is a block diagram schematically illustrating an architecture of a computer system in an embodiment of the present invention;
FIG. 2 is a flowchart showing a processing sequence executed by a signal control unit and a disk controller of FIG. 1;
FIG. 3 is a flowchart showing a processing sequence executed by the signal control unit and the disk controller of FIG. 1; and
FIG. 4 is an explanatory diagram of a data flow in the computer system in this embodiment.

### DESCRIPTION OF THE PREFERRED EMBODIMENT

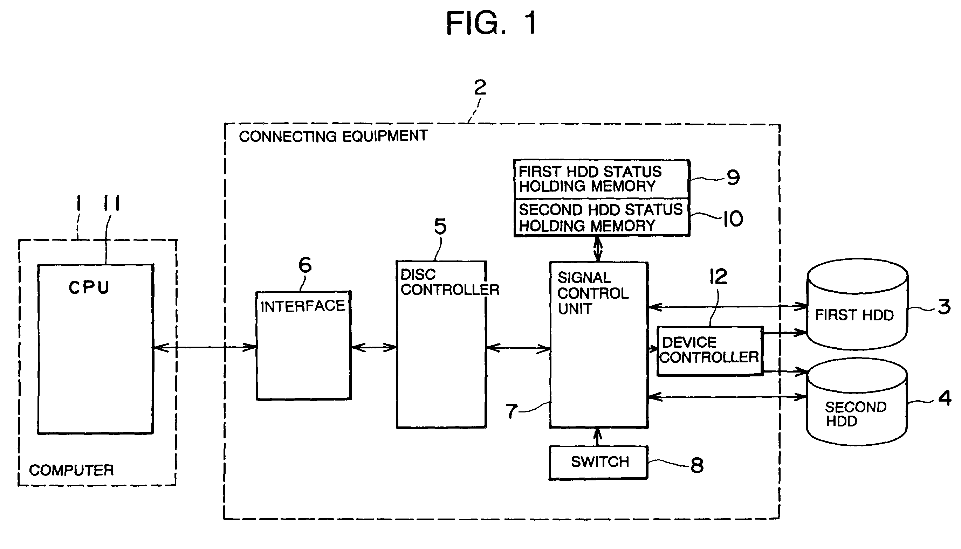

An embodiment of the present invention will hereinafter be discussed with reference to FIGS. 1 through 4.

FIG. 1 is a block diagram schematically illustrating an architecture of a computer system in accordance with this embodiment. As illustrated in FIG. 1, the computer system in this embodiment is constructed of a computer 1, a connecting equipment 2 connected to this computer 1 and two units of hard disk drives (first HDD 3, second HDD 4) connected to this connecting equipment 2.

The computer 1 incorporates a CPU (Central Processing Unit) 11. This CPU 11 instructs and controls a transfer and a receipt of data between the devices constituting the computer system.

The first HDD 3 is an update external storage device to which the latest data are always written. The second HDD 4 functions, when the switching equipment 2 is in a mirror disk mode, as a backup external storage device to which the same data as those in the first HDD 3 are written but functions, when in a parallel mode, as an update external storage device separate from the first HDD 3.

The switching equipment 2 is an equipment for controlling an exchange of the data as a supplement to the CPU 11 incapable of directly controlling the respective HDDs 3 and 4. This switching equipment 2 switches the above mirror disk mode and parallel mode. The switching equipment 2 issues, when in the parallel mode, a write and read instruction to only the HDD 3 or 4 designated by the CPU 11 and issues, when in the mirror disk mode, a write or read instruction to both or one of the HDDs 3, 4 in accordance with a condition of a fault in the HDDs 3, 4.

This switching equipment 2 is, to describe it in greater detail, constructed of an interface 6 for transferring and receiving the data directly to and from the CPU 11 of the computer 1, a disk controller 5 connected to this interface 6, a signal control unit 7 connected to this disk controller 5 and also to each of the HDDs 3, 4, a switch 8 connected to this signal control unit 7, a first HDD status holding memory 9, a second HDD status holding memory 10 and a device controller 12.

The disk controller 5 receives, when in a writing process, the write instruction (including information for specifying the write target HDD and data to be written) from the CPU 11 via the interface 6 and then transfers it to the signal control unit 7. Further, the disk controller 5 receives, when in a reading process, the read instruction (including information for specifying the read HDD and information for specifying an address for data to be read) from the CPU 11 via the interface 6 and then transfers it to the signal control unit 7. Then, the disk controller 5 receives the read data from the signal control unit 7 and transfers the same data to the CPU 11 via the interface 6.

The switch 8 is turned ON/OFF by a manual operation from outside of the switching equipment 2 and makes the signal control unit 7 switch over the above parallel mode (ON-time) and mirror disk mode (OFF-time).

The respective HDD status holding memories 9, 10 are memories for recording that the individual HDDs 3, 4 are normal (as a value "0") or that a fault happens therein (as the value "1").

The signal control unit 7 is a sequencer for switching over statuses of the above-mentioned mirror disk mode and parallel mode in accordance with the state of the switch 8 and allocating the write and read instructions transferred from the disk controller 5 to the HDDs 3, 4 in accordance with the respective modes and the data for specifying the write or read target HDD that is contained in each instruction. When receiving the write or read instruction (the write or read target thereof is set to the first HDD 3 or the second HDD 4), e.g. in the parallel mode, the signal control unit 7 transmits the one specified HDD 3 or 4. Further, when receiving the write or read instruction (the write or read target thereof is set to the first HDD 3) in the mirror disk mode, the signal control unit 7 transmits the instruction to both of the first HDD 3 and the second HDD 4.

Connected also to this signal control unit 7 is a device controller 12 for controlling the respective units such as a motor for the HDDs 3, 4. This device controller 12 controls operations of the respective portions of the individual HDDs 3, 4 (such as a disk rotation control, head tracking control) according to indications given from the signal control unit 7. That is, the signal control unit 7, when the write instruction issued in the mirror disk mode, cooperates with this device controller 12 and transmits the data contained in the write instruction in synchronization so that the data are synchronously written to every corresponding sectors of the respective HDDs 3, 4. Therefore, the same processing is invariably effected on the corresponding sectors on the HDDs 3, 4, and disk magnetic surfaces that are completely coincident in terms of a logical aspect and a physical aspect as well continue to be formed, whereby it is possible to make a preparation against an occurrence of a prospective fault.

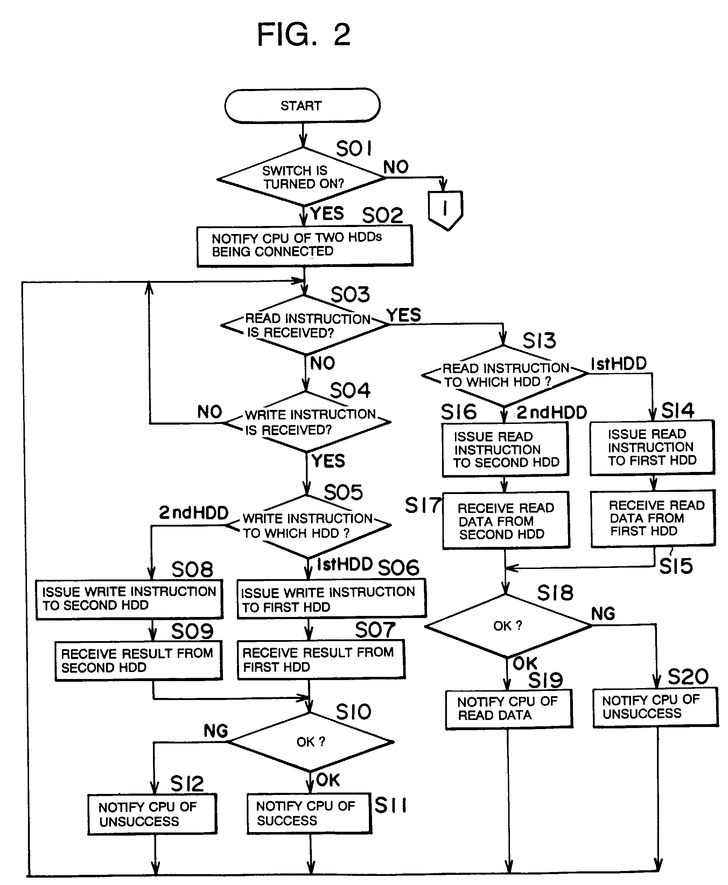

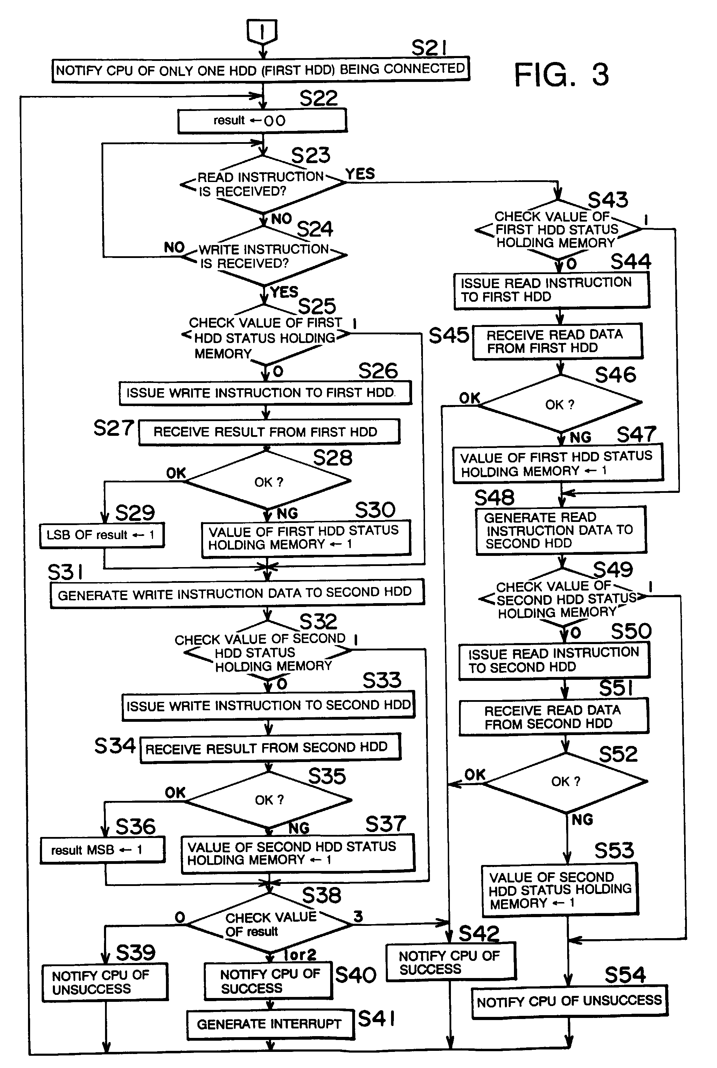

FIG. 2 and FIG. 3 are flowcharts showing an order of sequential control executed by the signal control unit 7. The processing in this flowchart is started upon a power supply of the computer system. In a first step S01 after the start thereof, a state of the switch 8 is checked. Then, when the switch 8 is turned ON, the processing enters the above-described parallel mode, and the CPU 11 is notified of the effect that the two hard disk drives (HDDs) are connected (S02). The CPU 11 receiving this notice recognizes the first HDD 3 and the second HDD 4 as devices independent of each other and is therefore capable of issuing the write and read instructions even if either the HDD 3 or the HDD 4 is designated as a write or read target.

In next step S03, whether or not the read instruction is made by the CPU 11 is checked. Subsequently, if the read instruction is not yet made, whether or not the write instruction is made by the CPU 11 is checked in step S04. Then, if no write instruction is made, the processing returns to step S03, wherein the above checking processes are repeated.

When determining that the write instruction has been made in step S04, the signal control unit 7 checks which drive is a target hard disk drive (HDD 3 or 4) for this write instruction in step S05. If it is determined that the target for the write instruction is the first HDD 3, the write instruction is issued to the first HDD 3 in step S06. A device drive unit for the first HDD 3 receiving this write instruction goes on recording the write data contained in the write instruction on a data recording surface on the disk. In next step S07, the signal control unit 7 receives a result showing whether the writing process has been successful or not from the first HDD 3. On the other hand, if it is determined that the target of the write instruction is the second HDD 4, the write instruction is issued to the second HDD 4 in step S08. The device drive unit for the second HDD 4 receiving this write instruction goes on recording the write data contained in the write instruction on the data recording surface on the disk. In next step S09, there is received a result showing whether the writing process has been successful or not from the second HDD 4.

In any case, whether or not the result received in step S07 or S09 shows the success in the writing process is checked in next step S10. Then, if successful (OK), the CPU 11 is notified of the success in step S11. Whereas if unsuccessful (NG), the CPU 11 is notified of the unsuccess in step S12. In any case, the processing goes back to step S03 in order to wait a next write or read instruction.

While on the other hand, when determining that the read instruction has been made in step S03, the signal control unit 7 checks which drive is a target hard disk drive HDD 3 or 4 for this read instruction in step S13. Then, if it is determined that the read instruction to the first HDD 3, the read instruction is issued to the first HDD 3 in step S14. The device drive unit for the first HDD 3 receiving this read instruction reads the data from a position of a data address contained in the read instruction. In next step S15, the signal control unit 7 receives the thus read data from the first HDD 3. On the other hand, if it is determined that the read instruction to the second HDD 4 has been made, the read instruction is issued to the second HDD 4 in step S16. The device drive unit for the second HDD 4 receiving this read instruction reads the data from the position of the data address contained in the read instruction. In next step S17, the signal control unit 7 receives the thus read data from this second HDD 4.

In any case, whether or not the read data has been normally received in step S15 or S17 is checked in next step S18. Then, if the read data has been normally received (OK), the CPU 11 is notified of the read data in step S19. Whereas if not normally received (NG), the CPU 11 is notified of the unsuccess in step S20. In any case, the processing returns to step S03 in order to wait a next write or read instruction.

While on the other hand, if it is determined that the switch 8 is turned OFF in step S01, the processing enters the above-described mirror disk mode, and the CPU 11 is notified of the effect that one hard disk drive (the first HDD 3) is connected (S21). The CPU 11 receiving this notice is capable of issuing only such a write or read instruction designating the first HDD 3 as a write or read target drive. In next S22, a 2-bit variable "result" is reset to "00".

In next step S23, whether or not the read instruction is made by the CPU 11 is checked. Subsequently, if the read instruction is not yet made, whether or not the write instruction is made by the CPU 11 is checked in step S24. Then, if no write instruction is made, the processing returns to step S23, wherein the above checking processes are repeated.

When determining that the write instruction has been made in step S24, the signal control unit 7 checks a value of the first HDD status holding memory 9 in step S25. Then, if the value thereof is "1 (abnormal)", the processing proceeds directly to step S31. If the value thereof is "0 (normal)", the processing proceeds to step S26. In this step S26, the write instruction is issued to the first HDD 3. That is, the signal control unit 7 issues the write instruction wherein the first HDD 3 is designated as a write target drive. The device drive unit for the first HDD 3 receiving this write instruction goes on recording the write data contained in the write instruction on the data recording surface on the disk.

In next step S27, the signal control unit 7 receives a result showing whether the writing process has been successful or not from the first HDD 3. Then, whether or not the result received in step S27 shows the success in the writing process is checked in next step S28. Then, if successful (OK), in step S29, an LSB (Least Significant Bit) of the variable "result" is set to "1". Whereas if unsuccessful (NG), the value of the first HDD status holding memory 9 is set to "1" in step S30. In any case, next, the processing proceeds to step S31.

In step S31, write instruction data to the second HDD 4 is generated. That is, only the write target drive in the write instruction to the first HDD 3 issued in step S26 is rewritten to the second HDD 4.

In next step S32, a value of the second HDD status holding memory 10 is checked. Then, if the value thereof is "1 (abnormal)", the processing proceeds directly to step S38. If the value thereof is "0 (normal)", the processing proceeds to step S33. In this step S33, the write instruction is issued to the second HDD 4. That is, the signal control unit 7 issues the write instruction generated in step S31. The device drive unit for the second HDD 4 receiving this write instruction goes on recording the write data contained in the write instruction on the data recording surface on the disk. On this occasion, the device drive unit for the second HDD 4 records the data which synchronizing it for every sectors so that the same data is recorded on the same sectors of the first and second HDDs 3, 4.

In next step S34, the signal control unit 7 receives a result showing whether the writing process has been successful or not from the second HDD 4. Then, whether or not the result received in step S34 shows the success in the writing process is checked in next step S35. Then, if successful (OK), in step S36, an MSB (Most Significant Bit) of the variable "result" is set to "1". Whereas if unsuccessful (NG), the value of the second HDD status holding memory 10 is set to "1" in step S37. In any case, next, the processing proceeds to step S38.

In step S38, the value of the variable "result" is checked. Then, if the value thereof is "0 (00)", the CPU 11 is notified of the unsuccess in the writing process in step S39. Whereas if the value thereof is "3 (11)", the CPU 11 is notified of the success in the writing process in step S42. Then, if the value thereof is "1 (01)" or "2 (10)", the CPU 11 is notified of the success in the writing process in step S40, and an interrupt indicating a fault in the device is caused in step S41. This interrupt is processed by an OS (Operating System) or a device driver executed in the CPU 11, and an operator can be notified of the device fault thereof. The operator receiving this notice of fault recognizes a non-backup status from the mirror disk but is capable of continuing the work as it is (in this case, the data are written to the first HDD 3 or the second HDD 4 where no fault happens and are read also therefrom). The operator, when desiring a restoration of the mirror disk status, temporarily stops the whole computer system and, thereafter, replaces the hard disk drive (HDD) where the abnormal state is caused with a new drive. Then, the operator copies the data written to the hard disk drive (HDD) with no fault into the new hard disk drive and restarts the computer system. In any case, the processing returns to step S22 in order to wait a next write or read instruction.

While on the other hand, when determining that the read instruction has been made in step S23, the signal control unit 7 checks the value of the first HDD status holding memory 9 in step S43. Then, if the value thereof is "1 (abnormal)", the processing proceeds directly to step S48. If the value thereof is "0 (normal)", the processing proceeds to step S44. In this step S44, the read instruction is issued to the first HDD 3. That is, the signal control unit 7 issues the read instruction wherein the first HDD 3 is designated as a read target drive. The device drive unit for the first HDD 3 receiving this read instruction reads the data from the position of the data address contained in the read instruction.

In next step S45, the signal control unit 7 receives the thus read data from the first HDD 3. Then, in next step S46, whether or not the read data has been normally received in step S45 is checked. Then, if the read data is normally received (OK), the CPU 11 is notified of the success in the reading process in step S42, and the processing goes back to step S22. Whereas if the read data is not normally received (NG), the value of the first HDD status holding memory 9 is set to "1" in step S47, and the processing proceeds to step S48.

In step S48, the read instruction data to the second HDD 4 is generated. That is, only the read target drive in the read instruction to the first HDD 3 issued in step S44 is rewritten to the second HDD 4.

In next step S49, the value of the second HDD status holding memory 10 is checked. Then, if the value thereof is "1 (abnormal)", the processing proceeds directly to step S54. If the value thereof is "0 (normal)", the processing proceeds to step S50. In this step S50, the read instruction is issued to the second HDD 4. That is, the signal control unit 7 issues the read instruction generated in S48. The device drive unit for the second HDD 4 receiving this read instruction reads the data from the position of the data address contained in the read instruction.

In next step S51, the signal control unit 7 receives the read data from the second HDD 4. Then, whether or not the read data has been normally received in step S51 is checked in next step S52. Then, if the read data has been normally received (OK), the CPU 11 is notified of the success in the reading process in step S42, and the processing returns to step S22. Whereas if not normally received (NG), the value of the second HDD status holding memory 10 is set to "1" in step S53 and, the CPU 11 is notified of the unsuccess in the reading process in step S54, and thereafter the processing returns to step S22.

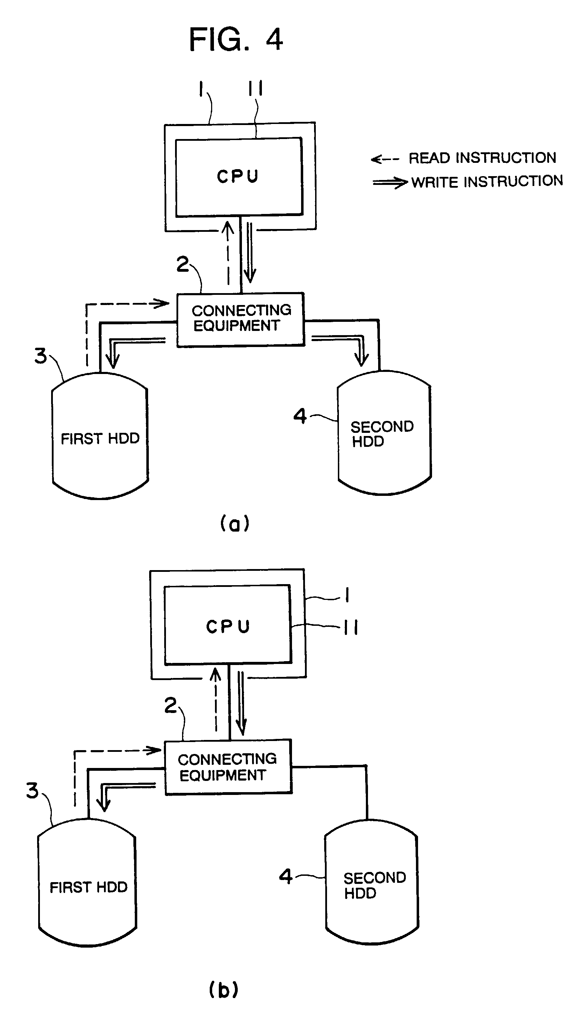

Next, the operation of the thus constructed computer system in this embodiment will be described with reference to FIG. 4. FIG. 4(a) illustrates a state of a case where the connecting equipment 2 comes in the mirror disk mode because the switch 8 of the connecting equipment 2 is turned OFF, but the fault does not happen in each device. As illustrated in FIG. 4(a), so far as the abnormality is not seen in each of the HDDs 3, 4, the connecting equipment 2, even when the CPU 11 recognizes only the first HDD 3 and outputs the write instruction thereto, transmits this write instruction to the first HDD 3 and the second HDD 4 as well. If the status that absolutely the same data are written to the two HDDs 3, 4 is ensured by performing the mirroring in this way, it is enough to read the data from one of the HDDs. Then, the connecting equipment 2 reads the data from only the first HDD 3 for the update.

FIG. 4(b) shows a state where the connecting equipment 2 is brought into the mirror disk mode, but the fault happens in the second HDD 4 or a state where the connecting equipment 2 is brought into the parallel mode because the switch 8 of the connecting equipment 2 is turned ON. In this case, the connecting equipment 2 issues the write instruction to only the first HDD 3 specified as the write target drive by the CPU 11 and also reads the data from only the first HDD 3.

An emphasis in this embodiment is placed on taking the sector-basis synchronization in terms of the hardware. Accordingly, a sector-basis content collation is not particularly adopted. This, in other words, implies that a necessity for the collation is small as far as the same processing is physically actualized on the sector-basis in a state where no fault happens, and hence there is no necessity for preparing the software for a special use. Accordingly, even when the read instruction is given from the central processing unit 1, the collating process is not performed. Then, the read instruction is transferred to one HDD in the same way as the majority of general mirror disk devices but transferred to the other HDD only when the fault happens in this one HDD.

As discussed above, according to the present invention, the so-called mirror disk system is constructed in terms of the hardware, thereby making the special-purpose software executed in the computer system unnecessary and besides making it possible to maintain the data by use of the existing external storage device.

Further, the data may be written while taking the synchronization on the every corresponding sector of the update external storage device and the backup storage device taken. With this arrangement, a highly-reliable system can be constructed without preparing the data collating/monitoring unit.

The invention being thus described, it will be obvious that the same may be varied in many ways. Such variations are not to be regarded as a departure from the spirit and scope of the invention, and all such modifications as would be obvious to one skilled in the art are intended to be included within the scope of the following claims.

## Claims

1. A computer system comprising:
a central processing unit;
a plurality of external storage devices; and
a repeater, connected to said central processing unit and said plurality of external storage devices, for transmitting a data write instruction for one specified external storage device among said plurality of external storage devices which is given from said central processing unit to this one specified external storage device and other external storage device as well.

2. A computer system according to claim 1, wherein said repeater switches over a first status where the data write instruction is transmitted to said one specified external storage device and said other external storage device and a second status where the data write instruction is transmitted to only said one specified external storage device in accordance with an outside operation.

3. A computer system according to claim 1, wherein said repeater includes fault detecting means for detecting whether or not a fault is caused in each of said external storage devices and transmits the write instruction to only said external storage device with no fault.

4. A computer system according to claim 1, wherein said repeater notifies said central processing unit of a success in the writing process when the data is written by one of said external storage devices on the basis of the data write instruction.

5. A computer system according to claim 1, wherein said repeater transmits a data read instruction for one specified external storage device among said external storage devices which is given from said central processing unit only to this one specified external storage device.

6. A repeater connected between a central processing unit and a plurality of external storage devices and transmitting a data write instruction for one specified external storage device among said external storage devices which is given from said central processing unit to said one specified external storage device and other external storage device as well.
